(19) **Europäisches Patentamt / European Patent Office / Office européen des brevets**

(11) **EP 4 752 395 A1**

(12) **EUROPEAN PATENT APPLICATION**
published in accordance with Art. 153(4) EPC

(43) Date of publication:
03.06.2026 Bulletin 2026/23

(21) Application number: 25813246.3

(22) Date of filing: 09.10.2025

(51) International Patent Classification (IPC):
*F16F 15/02* (2006.01)     *G06F 30/17* (2020.01)

(86) International application number:
PCT/CN2025/126427

(87) International publication number:
WO 2026/077372 (16.04.2026 Gazette 2026/16)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 08.10.2024  CN 202411393911
08.10.2024  CN 202411393912

(71) Applicant: Zhuzhou Times New Material
Technology Co., Ltd.
Zhuzhou, Hunan 412007 (CN)

(72) Inventors:
• XIA, Junyong
Zhuzhou, Hunan 412007 (CN)
• NING, Xiangliang
Zhuzhou, Hunan 412007 (CN)
• WANG, Weiqiang
Zhuzhou, Hunan 412007 (CN)
• OUYANG, Liu
Zhuzhou, Hunan 412007 (CN)
• LENG, Xinyun
Zhuzhou, Hunan 412007 (CN)
• LI, Peilu
Zhuzhou, Hunan 412007 (CN)
• JIN, Jie
Zhuzhou, Hunan 412007 (CN)
• ZHOU, Hanyu
Zhuzhou, Hunan 412007 (CN)
• LIU, Jun
Zhuzhou, Hunan 412007 (CN)
• DENG, Jiao
Zhuzhou, Hunan 412007 (CN)
• GUI, Changren
Zhuzhou, Hunan 412007 (CN)
• KONG, Lingjun
Zhuzhou, Hunan 412007 (CN)

(74) Representative: Laine IP Oy
Porkkalankatu 24
00180 Helsinki (FI)

(54) **BUFFER CONNECTING DEVICE AND PARAMETER CALCULATION METHOD THEREFOR**

(57) The present invention relates to the technical field of vibration reduction of device, and specifically to a buffer connection device and a parameter calculation method thereof. The buffer connection device comprises a bolt which includes a screw and a head. The screw passes through a first component and a second component in sequence. The buffer connection device further comprises a force transmission member arranged between the head and the first component, and configured such that a central axis of a first through hole of the first component remains to substantially coincide with a central axis of the head.

Fig. 1

**Description**

Cross Reference of Related Applications

The present application claims the priorities of Chinese patent application No. 202411393912.X entitled "A Connection Buffer Structural Member" and filed on October 8, 2024, and Chinese patent application No. 202411393911.5 entitled "Parameter Calculation Method for Connection Structural Member and Connection Structural Member" and filed on October 8, 2024, the entire content of which is incorporated herein by reference.

Technical Field

The present invention relates to the technical field of vibration reduction in apparatus, and specifically to a buffer connection device and a parameter calculation method thereof.

Technical Background

In a fixed connection system of two components in contact with each other, anchor bolts serve as main components to achieve the connection, such as the connection between two steel plates. The anchor bolts serve as both main connection points and weak links between the two components. Under external forces, anchor bolts are often sheared off or deformed and damaged, which affects the safety of the components and demands serious attention.

In a connection system of two steel plates, through holes or threaded holes are often evenly arranged around peripheries of the two steel plates, and the anchor bolts are placed in these through holes or threaded holes to achieve fixed connection, so that the anchor bolts can evenly bear the horizontal loads of the two steel plates.

There is a small gap existing between the anchor bolt and the through hole of the steel plate. Therefore, the anchor bolts which are regularly distributed (i.e. an axis of the anchor bolt coincides with a center line of the respective through hole or threaded hole) can easily become irregularly distributed after installation, resulting in uneven force distribution on the anchor bolts and excessive local force on a certain anchor bolt. In addition, due to manufacturing tolerances or installation deviations, or both, the center line of the steel plate's through hole or threaded hole may not coincide with the axis of the anchor bolt, which will also lead to the uneven force distribution on the anchor bolts. Further, there may be an uneven force on a certain anchor bolt after the connection system of the two steel plates is impacted by external forces. It is difficult to resist the impact or extrusion of uneven force relying only on the strength of the anchor bolt *per se,* resulting in frequent breakage of the anchor bolts due to excessive stress.

Currently, common means for buffering and protecting anchor bolts, such as arranging an elastic element between the anchor bolts and the steel plate, can only provide the axial vibration damping for the anchor bolts, but have little effect on the tangential vibration damping of the anchor bolts. However, since the tangential external force applied to the anchor bolts by the two steel plates is much greater than the axial external force by the two steel plates, the above means have limited effect on reducing the risk of anchor bolt breakage.

Therefore, there is an urgent need to develop a buffer connection device that can more effectively reduce the risk of anchor bolt breakage.

Summary of the Invention

In view of at least one of the above technical problems, the present invention proposes a buffer connection device, and a parameter calculation method thereof.

According to the present invention, a buffer connection device for connecting at least a first component and a second component is provided, the device comprising:

a bolt including a screw and a head, the screw passing through a first through hole of the first component and extending to at least the second component, in order to connect the first component and the second component together; and
a force transmission member arranged between the head and the first component, and configured such that a central axis of the first through hole of the first component remains to substantially coincide with a central axis of the head.

In one specific embodiment, the force transmission member fits the first component through an inclined surface, and is configured to receive a preload force directed towards said first component, so that the central axis of the first through hole of the first component remains to substantially coincide with that of the head through the inclined surface and the preload force.

In one specific embodiment, a buffer body configured to generate said preload force is arranged between the force transmission member and the head.

In one specific embodiment, said buffer body is at least one of a helical spring, a disc spring, or an elastic element.

In one specific embodiment, the buffer body comprises at least one disc spring element arranged coaxially, which comprises a disc spring body for receiving a vertical force, and a guide ring arranged coaxially within the disc spring body for engaging with the screw.

In one specific embodiment, a thickness of said guide ring is less than that of said disc spring body.

In one specific embodiment, a guide cylinder is arranged around said buffer body for preventing eccentric loading of said buffer body.

In one specific embodiment, a washer is arranged between the buffer body and the head, wherein a first end of said guide cylinder is connected to said washer, and a second end thereof is in contact with said first component.

In one specific embodiment, said force transmission member is configured as any one of a truncated cone, a prismatic frustum, and a spherical segment, thereby forming said inclined surface.

In one specific embodiment, an inclination angle of said inclined surface is 10° to 60°.

In one specific embodiment, said buffer body has a vertical stiffness $K_V$, which is obtained by an equation:

$$K_V = F_V / S_2$$

wherein $F_V$ denotes a vertical reaction force of said buffer body, and $S_2$ denotes a vertical compression displacement of said buffer body under $F_V$;
the vertical reaction force $F_V$ is obtained by an equation:

$$F_V = \alpha \left( F_{H1} - \mu_1 P \right)$$

wherein $\alpha$ denotes a force transmission coefficient of the buffer body, $F_{H1}$ denotes an external stress on the first component, $\mu_1$ denotes a sliding friction coefficient between the first component and the second component, and $P$ denotes an external vertical force between the first component and the second component;
the vertical compression displacement $S_2$ is obtained by an equation:

$$S_2 = S_1 \tan \theta$$

wherein $S_1$ denotes a horizontal sliding displacement of said first component under said external stress, and $\theta$ denotes the inclination angle of said inclined surface; and
the external stress $F_{H1}$ is obtained by an equation:

$$F_{H1} = \frac{F_V}{\alpha} + \mu_1 P .$$

In one specific embodiment, said buffer connection device has an initial stiffness $K_1$, which is obtained by an equation:

$$K_1 = \mu_1 \frac{P}{S_0}$$

wherein:

$\mu_1$ denotes the sliding friction coefficient between the first component and the second component;
$P$ denotes the external vertical force between the first component and the second component; and
$S_0$ denotes a horizontal sliding displacement when said first component overcomes static friction and begins to slide.

In one specific embodiment, said buffer connection device has a post-yield stiffness $K_2$, which is obtained by equations:

$$K_2 = \frac{F_V}{\alpha S_1} \quad \text{or} \quad K_2 = \frac{F_{H1} - \mu_1 P}{S_1 - S_0}$$

wherein $\alpha$ denotes the force transmission coefficient of the buffer body, $S_1$ denotes the horizontal sliding displacement of said first component under said external stress $F_{H1}$, where $S_1$ is larger than $S_0$, $F_{H1}$ denotes said external stress, $\mu_1$ denotes the sliding friction coefficient between the first component and the second component, and $P$ denotes the external vertical force between the first component and the second component.

In one specific embodiment, the force transmission coefficient $\alpha$ of the buffer body is obtained by an equation:

$$\alpha = \frac{\left(1 - \mu_2\mu_3\right)\cos\theta - \left(\mu_2 + \mu_3\right)\sin\theta}{\left(\mu_1 + \mu_2\right)\cos\theta + \left(1 - \mu_1\mu_2\right)\sin\theta}$$

wherein $\mu_2$ denotes a sliding friction coefficient between the inclined surface of the force transmission member and the first component, $\mu_3$ denotes a sliding friction coefficient between the bolt and the force transmission member, and $\theta$ denotes the inclination angle of said inclined surface.

In one specific embodiment, the bolt has a horizontal reaction force $F_{H2}$, which is obtained by an equation:

$$F_{H2} = \beta\left(F_{H1} - \mu_1 P\right)$$

wherein $F_{H2}$ denotes the horizontal reaction force of the bolt, $\beta$ denotes a force transmission coefficient of the bolt, $F_{H1}$ denotes the external stress, $\mu_1$ denotes the sliding friction coefficient between the first component and the second component, and P denotes the external vertical force between the first component and the second component.

In one specific embodiment, the force transmission coefficient $\beta$ of the bolt is obtained by an equation:

$$\beta = \frac{\mu_2\cos\theta + \sin\theta}{\left(\mu_1 + \mu_2\right)\cos\theta + \left(1 - \mu_1\mu_2\right)\sin\theta}$$

wherein $\mu_2$ denotes the sliding friction coefficient between the inclined surface of the force transmission member and the first component, and $\theta$ denotes the inclination angle of said inclined surface.

The present invention further proposes a parameter calculation method of the buffer connection device, wherein a vertical stiffness $K_V$ of the buffer body is obtained by an equation:

$$K_V = F_V / S_2$$

wherein $F_V$ denotes a vertical reaction force of the buffer body, and $S_2$ denotes a vertical compression displacement of said buffer body under $F_V$;
the vertical reaction force $F_V$ is obtained by an equation:

$$F_V = \alpha\left(F_{H1} - \mu_1 P\right)$$

wherein $\alpha$ denotes a force transmission coefficient of the buffer body, $F_{H1}$ denotes an external stress on the first component, $\mu_1$ denotes a sliding friction coefficient between the first component and the second component, and $P$ denotes an external vertical force between the first component and the second component;
the vertical compression displacement $S_2$ is obtained by an equation:

$$S_2 = S_1 \tan\theta$$

wherein $S_1$ denotes a horizontal sliding displacement of said first component under said external stress, and $\theta$ denotes the inclination angle of said inclined surface; and
the external stress $F_{H1}$ is obtained by an equation:

$$F_{H1} = \frac{F_V}{\alpha} + \mu_1 P \,.$$

In one specific embodiment, an initial stiffness $K_1$ of said buffer connection device is obtained by an equation:

$$K_1 = \mu_1 \frac{P}{S_0}$$

wherein:

$\mu_1$ denotes a sliding friction coefficient between the first component and the second component;
$P$ denotes an external vertical force between the first component and the second component; and
$S_0$ denotes a horizontal sliding displacement when said first component overcomes static friction and begins to slide; and
a post-yield stiffness $K_2$ of said buffer connection device is obtained by equations:

$$K_2 = \frac{F_V}{\alpha S_1} \quad \text{or} \quad K_2 = \frac{F_{H1} - \mu_1 P}{S_1 - S_0}$$

wherein $\alpha$ denotes the force transmission coefficient of the buffer body, $S_1$ denotes the horizontal sliding displacement of said first component under said external stress $F_{H1}$, where $S_1$ is larger than $S_0$, $F_{H1}$ denotes said external stress, $\mu_1$ denotes the sliding friction coefficient between the first component and the second component, and $P$ denotes the external vertical force between the first component and the second component.

In one specific embodiment, the force transmission coefficient $\alpha$ of the buffer body is obtained by an equation:

$$\alpha = \frac{(1 - \mu_2\mu_3)\cos\theta - (\mu_2 + \mu_3)\sin\theta}{(\mu_1 + \mu_2)\cos\theta + (1 - \mu_1\mu_2)\sin\theta}$$

wherein $\mu_2$ denotes a sliding friction coefficient between the inclined surface of the force transmission member and the first component, $\mu_3$ denotes a sliding friction coefficient between the bolt and the force transmission member, and $\theta$ denotes the inclination angle of said inclined surface.

In one specific embodiment, a horizontal reaction force $F_{H2}$ of the bolt is obtained by an equation:

$$F_{H2} = \beta(F_{H1} - \mu_1 P)$$

wherein $F_{H2}$ denotes the horizontal reaction force of the bolt, $\beta$ denotes a force transmission coefficient of the bolt, $F_{H1}$ denotes the external stress, $\mu_1$ denotes the sliding friction coefficient between the first component and the second component, and $P$ denotes the external vertical force between the first component and the second component; and the force transmission coefficient $\beta$ of the bolt is obtained by an equation:

$$\beta = \frac{\mu_2\cos\theta + \sin\theta}{(\mu_1 + \mu_2)\cos\theta + (1 - \mu_1\mu_2)\sin\theta}$$

wherein $\mu_2$ denotes a sliding friction coefficient between the inclined surface of the force transmission member and the first component, and $\theta$ denotes the inclination angle of said inclined surface.

Compared with the prior arts, the present invention has at least the following advantages.

The buffer connection device according to the present invention comprises the buffer body and the force transmission member. The first component is capable of sliding horizontally within a certain range on the second component, which is closely associated with the vertical deformation of the buffer body, generating a hysteretic curve with post-yield stiffness. The force transmission member is in contact with the first component via an inclined surface, so that the horizontal displacement of the first component relative to the second component can be converted into the vertical deformation of the buffer body, thereby reducing the risk of the bolt being sheared by the first and second components. The buffer body can apply a preload force towards the first component on the force transmission member, so that via said preload force and the inclined surface, the central axis of the first through hole of the first component remains to substantially coincide with the central axis of the head. This prevents the direct contact between the first component and a side surface of the bolt, preventing the bolt from being sheared.

According to the present invention, the stiffness of the buffer connection device can be optimized with different inclination angles of the inclined surface between the force transmission member and the first component, thereby converting the vertical stiffness of the buffer connection device into the horizontal stiffness between the first and second components.

The buffer connection device according to the present invention closely links a horizontal energy dissipation hysteretic curve of a structure formed by fixing the first and second components with a vertical energy dissipation hysteretic curve thereof through the force transmission member, forming a combined hysteretic curve generated by the overall energy dissipation of the buffer structure. The constitutive relationship of the hysteretic curve resembles a bilinear model.

Through the force transmission member, the horizontal force on the first component can be linked with the vertical force on the buffer body. The first component overcomes the friction with the second component to slide horizontally and pushes the force transmission member to slide vertically, thereby compressing the buffer body to generate the vertical compression displacement. Thus, an integrated energy dissipation system comprising the horizontal and vertical sliding is formed through the first component, the force transmission member, the buffer body, the second component and the bolt. The initial stiffness, the post-yield stiffness, and the equivalent stiffness generated by the horizontal sliding of the first component are linked with the vertical compression stiffness of the buffer body and the inclination angle of the inclined surface of the force transmission member, facilitating the optimization of structural design of the force transmission member.

According to the method of the present invention, the force transmission coefficients $\alpha$ and $\beta$ can be altered by adjusting the inclination angle of the inclined surface of the force transmission member, thereby altering the vertical reaction force of the buffer body and the horizontal reaction force of the bolt. The horizontal reaction force of the bolt and the vertical reaction force of the buffer body are negatively correlated with the inclination angle of the inclined surface of the force transmission member. When the horizontal reaction force of the bolt is small, the inclination angle of the inclined surface of the force transmission member is small, while the vertical reaction force of the buffer body is large. Further, the vertical compression displacement of the buffer body is tangent to the horizontal sliding displacement of the first component with regard to the inclination angle of the inclined surface of the force transmission member. When the horizontal sliding displacement of the first component remains constant, the force transmission member with a small inclination angle of the inclined surface will result in the small vertical compression displacement of the buffer body. Therefore, by providing the force transmission member with a small inclination angle of the inclined surface, the buffer body with the small vertical compression displacement and the large vertical reaction force can be obtained, i.e. the buffer body with the large vertical stiffness that better meets the design requirements, which is beneficial to the buffer connection device with a small overall height.

According to the present invention, a guide ring is provided at the center of the buffer body. The guide ring is integrated with the disc spring body to form a special-shaped disc spring. The disc spring body provides vertical compression, while the guide ring only provides auxiliary guiding.

According to the method of the present invention, the guide cylinder of the buffer body and a washer at a top portion thereof are structurally optimized. The washer and the guide cylinder are integrally connected. A vertical clearance is maintained between a bottom portion of the guide cylinder and the first component, which equals the pre-compression displacement of the buffer body. After the buffer body is pre-compressed, the guide cylinder is in close contact with the first component, preventing eccentric loading on the buffer body after vertical compression that could cause large bending deformation of the bolt, and ensuring the vertical guiding function of the bolt.

Brief Description of the Drawings

The present invention will be described in detail below in conjunction with the accompanying drawings.

Fig. 1 schematically shows an embodiment of a buffer connection device according to the present invention.

Fig. 2 schematically shows a first component according to the present invention.

Fig. 3 schematically shows a buffer body comprising a plurality of disc spring elements in the buffer connection device according to the present invention.

Fig. 4 is a schematic partial enlargement view of Fig. 3.

Fig. 5 schematically shows an embodiment of the disc spring element according to the present invention.

Fig. 6 schematically shows a three-dimensional structure of the disc spring element according to an embodiment of the present invention.

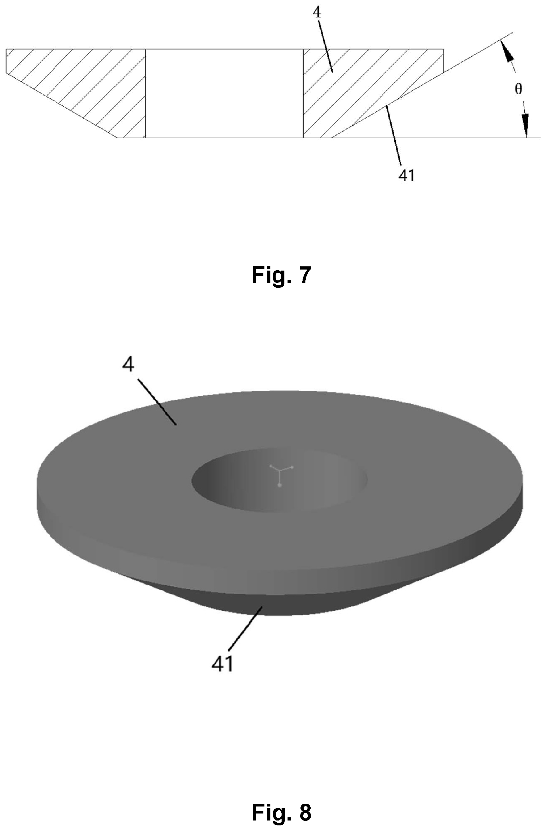

Fig. 7 schematically shows an embodiment of a force transmission member according to the present invention.

Fig. 8 schematically shows a three-dimensional structure of the force transmission member according to an embodiment of the present invention.

Fig. 9 schematically shows force decomposition of the first component according to the present invention.

Fig. 10 schematically shows force decomposition of the force transmission member according to the present invention.

Fig. 11 schematically shows an equivalent stiffness relationship.

Fig. 12 schematically shows a relationship between an inclination angle of an inclined surface of the force transmission member and a vertical reaction force of the buffer body as well as a horizontal reaction force of a screw.

Fig. 13 schematically shows a guide cylinder in the buffer connection device according to the present invention.

Fig. 14 is a schematic partial enlargement view of Fig. 13.

List of reference signs

1. bolt; 11. screw; 12. head;
2. washer;
3. buffer body; 30. disc spring element; 31. guide ring; 32. disc spring body; 33. guide cylinder;
4. force transmission member; 41. inclined surface; 42. second through hole;
61. first component; 611. first through hole; 62. second component; 621. threaded hole;
100. buffer connection device.

**In** the present application, all accompanying drawings are schematic ones, provided to illustrate the principle of the present invention merely, and are not necessarily drawn to actual scale.

Detailed Description of Embodiments

The present invention will be described below with reference to the accompanying drawings.

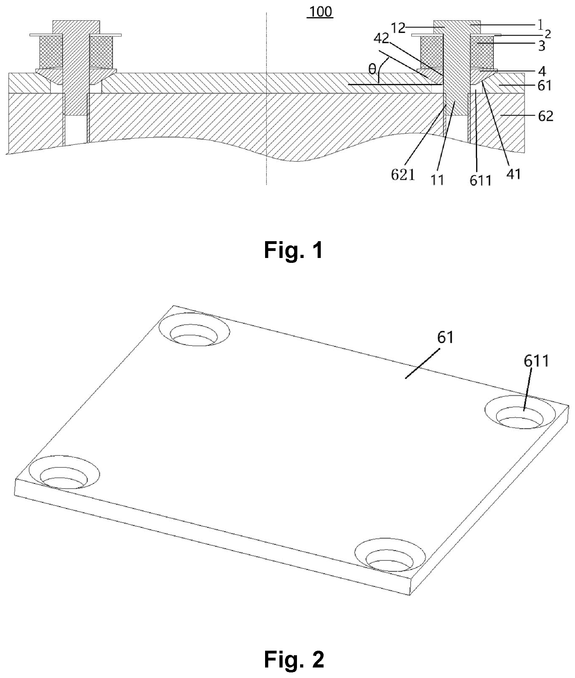

It should be noted that in the present invention, directional terms or expressions such as "upper", "lower", etc. are defined with reference to Fig. 1, which are not intended to limit absolute positions of the components involved, but may be varied according to specific circumstances.

Fig. 1 shows a structure of a buffer connection device 100 according to the present invention. As shown in Fig. 1, the buffer connection device 100 is configured to connect a first component 61 and a second component 62 together. In this embodiment, both the first component 61 and the second component 62 are steel plates. It should be noted that the first component 61 and the second component 62 may also be any other workpieces that need to be connected to each other. Additionally, it is readily understood that the buffer connection device 100 is not limited to connecting two components, but can also be used to connect multiple components (e.g., three, four, or more components) together. For convenience only, the connection of two components (i.e. the first component 61 and the second component 62) is described in this embodiment.

The buffer connection device 100 includes a bolt 1. The bolt 1 includes a screw 11 and a head 12, wherein a diameter of the head 12 is larger than a diameter of the screw 11, and external threads are provided on an end of the screw 11 away from the head 12. **In** order to facilitate the connection, a first through hole 611 is provided on the first component 61, and a threaded hole 621 is provided on the second component 62. A size of the first through hole 611 is larger than a size of the screw 11. Thus, the bolt 1 can pass through the first through hole 611 and engage with the threaded hole 621 through the external threads, thereby connecting the first component 61 and the second component 62 together. The first through hole 611 and the threaded hole 621 can generally be arranged around peripheries of the first component 61 and the second component 62, or at any locations as needed. The above structure is well known to those skilled in the art. Further, it is readily understood that the buffer connection device in the present invention may include various forms of threaded connectors, and the bolt 1 provided herein is only one example and is not intended to limit the scope of protection of the present invention.

As shown in Fig. 1, the buffer connection device 100 further includes a buffer body 3 and a force transmission member 4. **In** a specific embodiment, the buffer body 3 is a helical spring which is coaxially sleeved around the screw 11, with both ends thereof abutting against the head 12 and the force transmission member 4, respectively. In other embodiments according to the present invention, the buffer body 3 may be an elastic element made of polyurethane material or rubber material and sleeved on the screw 11.

The force transmission member 4 is coaxially sleeved around the screw 11. In a preferred embodiment of the present invention, the force transmission member 4 may be configured as any one of a truncated cone, a prismatic frustum, and a spherical cone. However, the specific shape of the force transmission member 4 is not limited thereto, as long as a contact surface between a lower end of the force transmission member 4 and the first component 61 forms an inclined surface 41 (i.e. there is an inclination angle $\theta$).

In this embodiment, the force transmission member 4 is in a truncated cone shape. The lower end of the force transmission member 4 forms the inclined surface 41. A second through hole 42 is formed penetrating through a center of the force transmission member 4. The screw 11 extends through the force transmission member 4 via the second through hole 42 to engage with the threaded hole 621 of the second component 62. Additionally, an inner diameter of the force transmission member 4 fits an outer diameter of the screw 11, and an outer wall of the screw 11 is in contact with the second through hole 42 of the force transmission member 4, allowing the force transmission member 4 to move along an axial direction of the screw 11.

An upper end of the first through hole 611 of the first component 61 has a shape conforming to the inclined surface 41 of the force transmission member 4. In this embodiment, an upper end surface of the first through hole 611 of the first component 61 is a conical surface that fits the inclined surface 41. In this manner, the inclined surface 41 of the force transmission member 4 is in contact with the conical surface at the upper end of the first component 61. Further, a top portion of the force transmission member 4 is in contact with the buffer body 3.

According to the present invention, as shown in Fig. 1, the screw 11 is inserted through the first through hole 611 of the first component 61, and a lower end of the screw 11 is fixedly connected to the threaded hole 621 of the second component 62 through the external threads. Since there is a gap between the screw 11 and the first through hole 611, a difference between an inner diameter of the first through hole 611 and the outer diameter of the screw 11 allows a range of horizontal displacement of the first component 61 relative to the second component 62. With such arrangement, there will be a large horizontal sliding displacement between the first component 61 and the second component 62, effectively preventing the first component 61 from being in direct contact with the screw 11, thereby avoiding transferring horizontal load to the bolt 1.

Additionally, the buffer connection device 100 according to the present invention further includes the force transmission member 4 and the buffer body 3. The first component 61, when moving horizontally relative to the second component 62, pushes the force transmission member 4 to move upward along the screw 11 via the inclined surface 41, thereby compressing the buffer body 3 to convert the horizontal load of the first component 61 into a vertical load. Meanwhile, the buffer body 3 is configured to apply a preload force to the force transmission member 4 that tends to move the force transmission member 4 towards the first component 61. In this manner, the force transmission member 4 would force the first component 61 to reset via the inclined surface 41, so that a central axis of the first through hole 611 of the first component 61 restores to substantially coincide with a central axis of the screw 11. Therefore, according to the present invention, direct horizontal contact between the first component 61 and the screw 11 can be avoided, thereby protecting the bolt 1 and eliminating the risk of breakage of the bolt 1 due to tangential stress.

It should be noted that the gap between the outer wall of the screw 11 and the first through hole 611 in the present invention is different from and much larger than the clearance fit in the mechanical field of the prior arts. In a preferred embodiment, a distance between the outer wall of the screw 11 and an inner wall of the first through hole 611 is greater than or equal to 10 mm. With such arrangement, there is a sufficient space for the first component 61 to move horizontally relative to the second component 62, thereby effectively converting the horizontal load into the vertical load to protect the bolt 1.

In a preferred embodiment, as shown in Fig. 1, an inclination angle $\theta$ of the inclined surface 41 is 10° to 60°, which can further enhance the protective effect on the bolt 1.

In a preferred embodiment, the contact surface between the force transmission member 4 and the first component 61 is subjected to a wear-resistant treatment. In a preferred embodiment, a contact surface between the force transmission member 4 and the bolt 1 is subjected to a wear-resistant treatment. In some specific examples, the wear-resistant treatment includes, but is not limited to applying a wear-resistant coating on at least one of the inclined surface 41 of the force transmission member 4, the upper end surface of the first through hole 611 of the first component 61 in contact with the inclined surface 41, an inner wall of the force transmission member 4, and a smooth outer wall of the bolt 1. Alternatively, a wear-resistant plate can be installed on at least one of the inclined surface 41 of the force transmission member 4, the upper end surface of the first through hole 611 of the first component 61 in contact with the inclined surface 41, and the inner wall of the force transmission member 4.

As shown in Fig. 1, the screw 11 passes through the first component 61 and the second component 62 sequentially from a top portion to a bottom portion thereof. The buffer body 3 and the force transmission member 4 are coaxially sleeved on the screw 11 sequentially from a top portion to a bottom portion thereof and arranged between the head 12 and the first component 61, wherein the buffer body 3 is arranged between the head 12 and the force transmission member 4. In this embodiment, the lower end of the screw 11 is directly connected to the threaded hole 621 of the second component 62 via the external threads, thereby providing the preload force for the buffer body 3. **In** an embodiment not shown, the lower end of the screw 11 passes through the second component 62, and is connected to the external threads at the lower end of the screw 11 via a nut on a surface of the second component 62 opposite to the first component 61, thereby providing the preload force for the buffer body 3.

According to the present invention, at least two buffer connection devices 100 are provided to connect the first component 61 and the second component 62. As shown in Fig. 2, in this embodiment, the first component 61 is in a square shape, and a first through hole 611 is provided at each of four corners of the first component 61. Correspondingly, threaded holes 621 are arranged at corresponding positions on the second component 62. Thus, the first component 61 and the second component 62 can be firmly connected to each other through four buffer connection devices 100.

**In** this embodiment, the first component 61 is a movable component, and the second component 62 is a fixed component. After fixing the first component 61 and the second component 62 together, the buffer connection devices 100 can provide a vertical pressure for the first component 61 and the second component 62. When the first component 61 is subjected to an external horizontal force, the first component 61 will slip horizontally relative to the second component 62. Most of the external energy can be dissipated based on friction energy dissipation between the first component 61 and the second component 62. The remaining external energy can be transmitted to the bolt 1 through both horizontal force and vertical force, thus providing a better buffer protection for the bolt 1. That is, the first component 61 causes the force transmission member 4 to move upward in a vertical direction through the inclined surface 41, in order to compress the buffer body 3 and convert the horizontal displacement of the first component 61 relative to the second component 62 into the vertical deformation of the buffer body 3, thus effectively reducing the horizontal tangential force on the bolt 1.

When the first component 61 undergoes a large horizontal movement, the horizontal load borne by the first component 61 can be uniformly distributed to a plurality of buffer connection devices 100 arranged on the first component 61. Through the force transmission members 4, the large horizontal load borne by the first component 61 can be converted into the vertical load on the bolts 1 of the plurality of buffer connection devices 100. In this manner, all the bolts 1 can be stressed simultaneously, reducing the stress on one single bolt 1, which further reduces the risk of breakage of the bolt 1. By adjusting the inclination angle of the inclined surface 41 of the force transmission member 4, the horizontal and vertical stresses on the bolt 1 can be analyzed and designed from different perspectives.

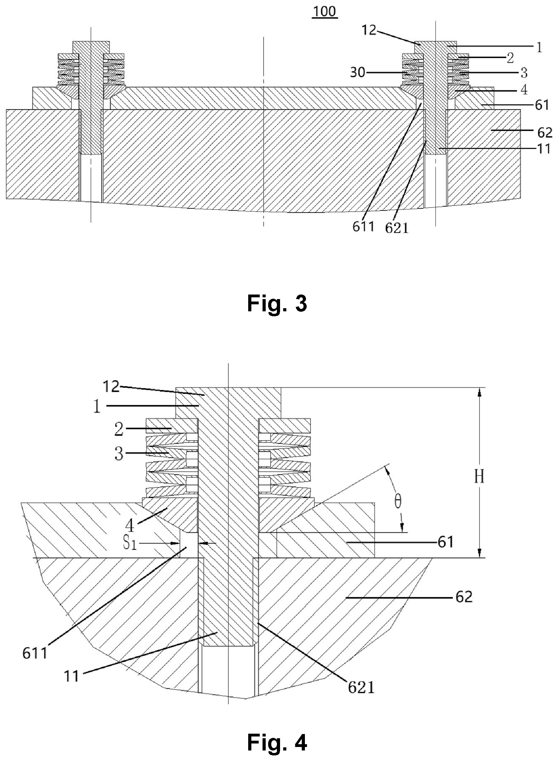

In an embodiment according to the present invention, the buffer body 3 includes at least one disc spring element 30 arranged coaxially, as shown in Figs. 3 and 4. In this embodiment, a plurality of disc spring elements 30 in both orientations is alternately sleeved outside the screw 11 sequentially along the axial direction. The specific number of the disc spring elements 30 can be adjusted according to actual needs in use.

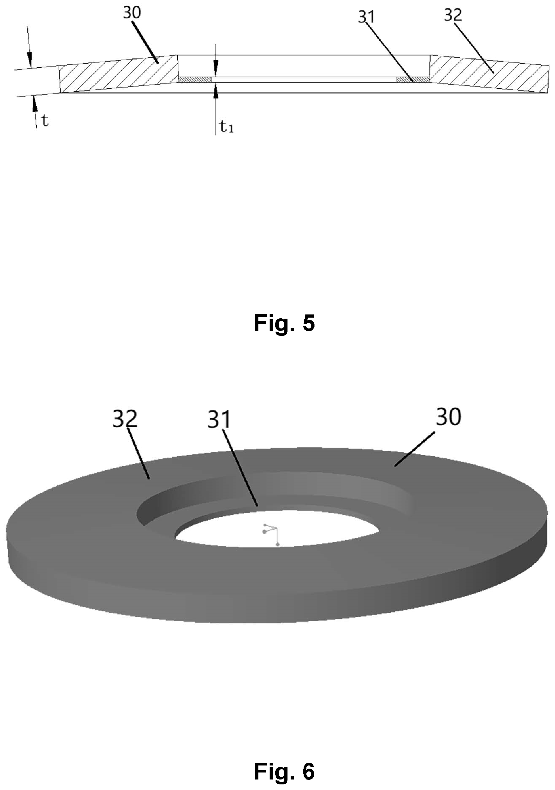

As shown in Figs. 5 and 6, each disc spring element 30 includes a guide ring 31 and a disc spring body 32. The guide ring 31 is flat and in a circular ring shape. An inner diameter of the guide ring 31 fits the outer diameter of the screw 11. That is, the inner diameter of the guide ring 31 is equal to a nominal diameter of the bolt 1, so that the guide ring 31 can be coaxially sleeved on the screw 11 and move axially along the screw 11. The disc spring body 32 is in a conical ring shape. An outer diameter of the guide ring 31 is equal to an inner diameter of the disc spring body 32, and an inner wall of the disc spring body 32 is fixed to an outer wall of the guide ring 31. In this embodiment, the disc spring body 32 and the guide ring 31 form an integral structure, or an outer side of the guide ring 31 is fixed to the disc spring body 32 through welding.

In a specific embodiment, a thickness of the guide ring 31 is less than or equal to a thickness of the disc spring body 32. As shown in Fig. 5, the thickness $t_1$ of the guide ring 31 is less than or equal to the thickness $t$ of the disc spring body 32. In this embodiment, the thickness of the guide ring 31 is much smaller than that of the disc spring body 32. The guide ring 31 provides auxiliary guiding to the buffer body 3, without bearing the vertical force of the buffer body 3.

In a specific embodiment, the buffer body 3 is a combination of a plurality of disc spring elements. Such arrangement offers the advantages such as reduced installation height, small vertical compression displacement, and large vertical bearing capacity.

In a preferred embodiment, a washer 2 is arranged between the buffer body 3 and the head 12, as shown in Fig. 4. An inner diameter of the washer 2 is smaller than an outer diameter of the head 12, and an outer diameter of the washer 2 is larger than an outer diameter of the buffer body 3. An upper end surface of the washer 2 axially abuts against a lower end surface of the head 12, and a lower end surface of the washer 2 axially abuts against an upper end surface of the buffer body 3. A lower end surface of the buffer body 3 axially abuts against an upper end surface of the force transmission member 4. The inclined surface 41 at the lower end of the force transmission member 4 abuts against the upper end surface of the first through hole 611 of the first component 61, and a lower end surface of the first component 61 axially abuts against an upper end surface of the second component 62.

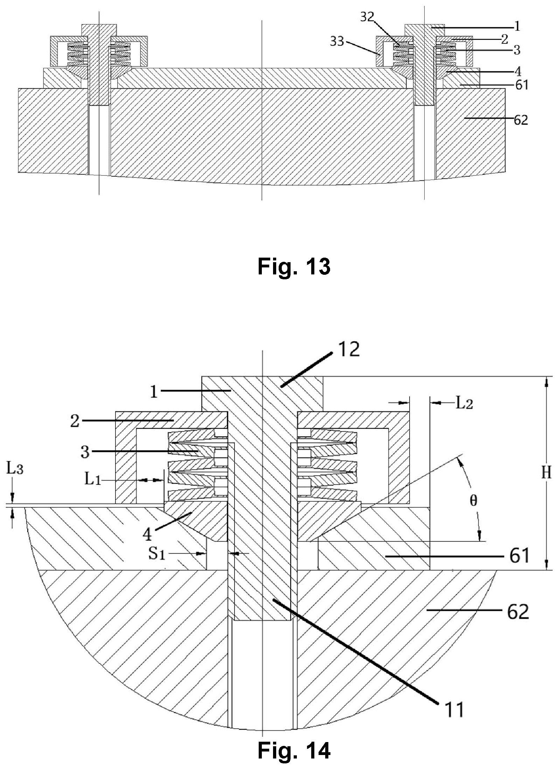

As shown in Figs. 13 and 14, in one embodiment according to the present invention, the buffer body 3 further includes a guide cylinder 33. The guide cylinder 33 is a circular sleeve, which is coaxially sleeved outside the bolt 1 and supported by the first component 61. The buffer body 3 (e.g. the disc spring body 32) is arranged inside the guide cylinder 33. For example, an upper end of the guide cylinder 33 may be integrated with the washer 2 through welding. A vertical gap between a bottom portion of the guide cylinder 33 and the first component 61 is L3, which is approximately equal to a pre-compression displacement of the buffer body 3. After the buffer body 3 is pre-compressed, the guide cylinder 33 and the first component 61 form a tight fit, thereby preventing eccentric load of the buffer body 3 after vertical compression, which could lead to significant bending deformation of the head of the bolt 1. Such deformation would result in the bolt 1 losing its vertical guiding effect for the buffer body 3. An appropriate horizontal gap L1 is provided between an inner wall of the guide cylinder 33 and an outer side of the force transmission member 4, while a horizontal gap L2 is also provided between an outer wall of the guide cylinder 33 and a periphery of the first component 61. The horizontal gap L2 is slightly larger than a horizontal gap S1 between the first through hole 611 of the first component 61 and the bolt 1, thus ensuring that the first component 61 does not lose its support for the guide cylinder 33 after a horizontal sliding displacement S1.

According to another aspect of the present invention, a parameter calculation method for the buffer connection device in the present invention is provided.

In the transmission of horizontal and vertical forces, the parameter calculation for the buffer connection device 100 mainly involves the calculation of stiffness, including initial stiffness, post-yield stiffness, and equivalent stiffness of a hysteresis curve formed by the horizontal sliding of the first component 61 relative to the second component 62, as well as vertical compression stiffness of the buffer body 3. Therefore, it is necessary to study and analyze the calculation of stiffness for the buffer connection device. Specifically, an in-depth investigation is conducted into the horizontal and vertical forces of the buffer connection device 100 according to the present invention after the first component 61 and the second component 62 are fixed together.

It is readily understood that vertical stiffness of the buffer body 3 is a ratio of a vertical reaction force $F_V$ from the force transmission member 4 on the buffer body 3 to a vertical compression displacement $S_2$ of the buffer body 3. The vertical reaction force $F_V$ from the force transmission member 4 on the buffer body 3 is mainly determined by forces on both the first component 61 and the force transmission member 4.

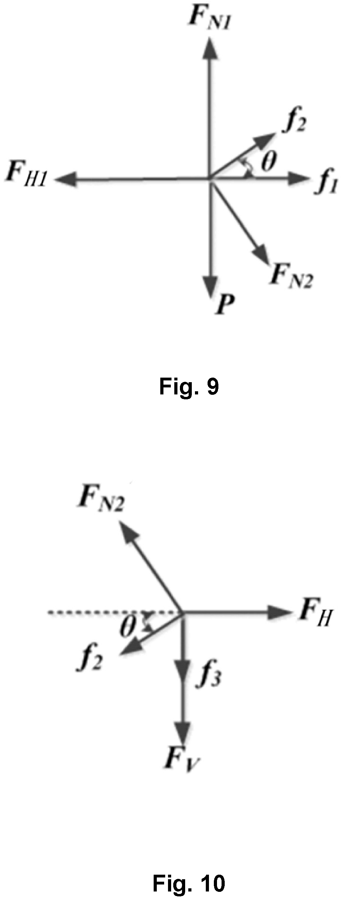

As shown in Fig. 9, the forces on the first component 61 include an external horizontal force $F_{H1}$, an external vertical force P, a vertical reaction force $F_{N1}$ and a horizontal friction force $f_1$ from the second component 62, and a normal reaction force $F_{N2}$ and a tangential friction force $f_2$ from the inclined surface of the force transmission member 4. As shown in Fig. 10, the forces on the force transmission member 4 include the vertical reaction force $F_V$ from the buffer body 3, the normal reaction force $F_{N2}$ and the tangential friction force $f_2$ from the inclined surface of the first through hole 611 of the first component 61, and a horizontal reaction force $F_H$ and a vertical friction force $f_3$ from the bolt 1.

A vertical stiffness $K_V$ of the buffer body 3 is a ratio of the vertical reaction force $F_V$ from the force transmission member 4 on the buffer body 3 to the vertical compression displacement $S_2$ of the buffer body 3. The vertical reaction force $F_V$ from the force transmission member 4 on the buffer body 3 is mainly determined by the forces on both the first component 61 and the force transmission member 4. As mentioned above, the forces on the first component 61 include the external horizontal force $F_{H1}$, the external vertical force P, the vertical reaction force $F_{N1}$ and the horizontal friction force $f_1$ from the second component 62, and the normal reaction force $F_{N2}$ and the tangential friction force $f_2$ from the inclined surface 41 of the force transmission member 4. Therefore, a horizontal direction equation (1.1) and a vertical force equation (1.2) derived from the first component 61 are:

$$F_{N1} + f_2 \sin\theta = P + F_{N2}\cos\theta \quad (1.1)$$

$$F_{H1} - f_1 - f_2\cos\theta - F_{N2}\sin\theta = ma \quad (1.2)$$

Similarly, as mentioned above, the forces on the force transmission member 4 include the vertical reaction force $F_V$ from the buffer body 3, the normal reaction force $F_{N2}^{'}$ and the tangential friction force $f_2^{'}$ from the inclined surface of the first through hole 611 of the first component 61, and the horizontal reaction force $F_{H2}$ and the vertical friction force $f_3$ from the bolt 1. Therefore, a horizontal direction equation (1.3) and a vertical force equation (1.4) derived from the force transmission member 4 are:

$$F_{N2}^{'}\cos\theta = f_2^{'}\sin\theta + f_3 + F_V \quad (1.3)$$

$$f_2^{'}\cos\theta + F_{N2}^{'}\sin\theta = F_{H2} \quad (1.4)$$

wherein $f_1 = \mu_1 F_{N1}$,  $f_2 = f_2^{'} = \mu_2 F_{N2} = \mu_2 F_{N2}^{'}$ , $f_3 = \mu_3 F_H$; $\mu_1$, $\mu_2$ and $\mu_3$ denote sliding friction coefficients between the first component 61 and the second component 62, between the inclined surface 41 of the force transmission member 4 and the inclined upper end surface of the first through hole 611 of the first component 61, and between the bolt 1 and the force transmission member 4, respectively; $\theta$ denotes the inclination angle of the inclined surface 41 of the force transmission member 4; $m$ denotes a mass of the first component 61 (a steel plate in this embodiment, $m=400$ kg); and a denotes a horizontal seismic acceleration, which equals to 0.15g, i.e. 1.47 m/s$^2$.

By simplifying equations (1.1) to (1.4), equations of the vertical reaction force $F_V$ of the buffer body 3 and the horizontal reaction force $F_{H2}$ of the bolt 1 are obtained as:

$$F_V = \alpha \left( F_{H1} - \mu_1 P \right) \quad (1.5)$$

$$F_{H2} = \beta \left( F_{H1} - \mu_1 P \right) \quad (1.6)$$

wherein $\alpha$ denotes a force transmission coefficient of the buffer body 3, $\alpha = \dfrac{\left(1 - \mu_2 \mu_3\right)\cos\theta - \left(\mu_2 + \mu_3\right)\sin\theta}{\left(\mu_1 + \mu_2\right)\cos\theta + \left(1 - \mu_1 \mu_2\right)\sin\theta}$ ; and

$\beta$ denotes a force transmission coefficient of the bolt 1, $\beta = \dfrac{\mu_2 \cos\theta + \sin\theta}{\left(\mu_1 + \mu_2\right)\cos\theta + \left(1 - \mu_1 \mu_2\right)\sin\theta}$ .

The vertical compression displacement $S_2$ of the buffer body 3 is mainly determined by the horizontal sliding of the first component 61 relative to the second component 62 and the vertical sliding of the force transmission member 4 relative to the first component 61. The first component 61, under the external horizontal force $F_{H1}$, generates a horizontal sliding displacement $S_1$, pushing the force transmission member 4 to slide vertically, thereby compressing the buffer body 3 that generates the vertical compression displacement $S_2$. The vertical compression displacement $S_2$ of the buffer body 3 is associated with the horizontal sliding displacement $S_1$ of the first component 61 and the inclination angle $\theta$ of the inclined surface 41 of the force transmission member 4, which is expressed as:

$$S_2 = S_1 \tan\theta \quad (1.9)$$

The first component 61 slides horizontally on the second component 62, generating horizontal hysteretic energy dissipation. A portion of this horizontal hysteretic energy dissipation is borne by frictional energy dissipation between the first component 61 and the second component 62, while the rest of the horizontal hysteretic energy dissipation is borne by vertical buffer energy dissipation generated by the force transmission member 4 and the buffer body 3. A hysteretic curve formed by the horizontal hysteretic energy dissipation of the first component 61 represents a constitutive relationship between the horizontal force $F_H$ and a horizontal displacement S of the first component 61. Specifically, in this embodiment, when the first component 61 slides horizontally under the external horizontal force $F_{H1}$, a relationship between the external horizontal force $F_{H1}$ of the first component 61, the vertical reaction force $F_V$ of the buffer body 3, and the inclination angle $\theta$ of the inclined surface 41 of the force transmission member 4 is expressed as:

$$F_{H1} = \frac{F_V}{\alpha} + \mu_1 P \quad (1.10)$$

Main parameters of the constitutive relationship include an initial displacement $S_0$, an initial stiffness $K_1$, a post-yield stiffness $K_2$, and an equivalent stiffness $K_{eff}$ of the first component 61. That is, when the first component 61 undergoes the horizontal sliding displacement $S_1$ under the external horizontal force $F_{H1}$, an equation of the equivalent stiffness $K_{eff}$ of the first component 61 is:

$$K_{eff} = \frac{F_{H1}}{S_1} = \frac{F_V}{\alpha S_1} + \mu_1 \frac{P}{S_1} \quad (1.11)$$

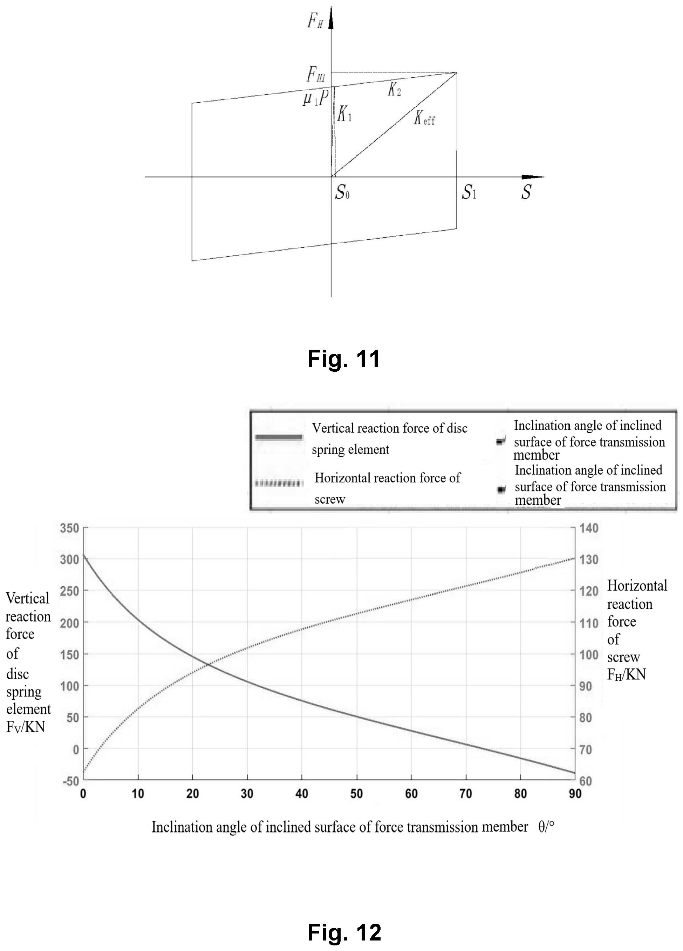

As shown in Fig. 11, the initial displacement $S_0$ involved in the constitutive relationship is a horizontal sliding displacement when the first component 61 overcomes a static friction with the second component 62 and begins to slide. When $S_1$ is less than or equal to $S_0$, the initial stiffness $K_1$ is a ratio of an isolation initiation force $\mu_1 P$ of the first component 61 to the initial displacement $S_0$, which is expressed as:

$$K_1 = \mu_1 \frac{P}{S_0} \quad (1.12)$$

wherein the isolation initiation force $\mu_1 P$ is a static friction force between the first component 61 and the second component 62.

When $S_1$ is larger than $S_0$, the post-yield stiffness $K_2$ is a slope between the horizontal sliding displacement $S_1$ and the initial displacement $S_0$ of the first component 61, i.e. a difference between the external horizontal force $F_{H1}$ and the isolation initiation force $\mu_1 P$ divided by a difference between the horizontal sliding displacement $S_1$ and the initial displacement $S_0$, which is expressed as:

$$K_2 = \frac{F_{H1} - \mu_1 P}{S_1 - S_0} \quad (1.13)$$

wherein the horizontal reaction force corresponding to the horizontal sliding displacement $S_1$ is the external horizontal force $F_{H1}$. Meanwhile, the equivalent stiffness $K_{eff}$ is equal to a ratio of the external horizontal force $F_{H1}$ to the horizontal sliding displacement $S_1$.

In another equation, the post-yield stiffness $K_2$ can also be calculated as follows:

$$K_2 = \frac{F_V}{\alpha S_1} \quad (1.14)$$

A relationship between the post-yield stiffness $K_2$ of the buffer connection device 100 and the vertical stiffness $K_V$ of an elastic element of the buffer connection device 100 is as follows:

$$K_2 = K_V \times \frac{\tan \theta}{\alpha} \quad (1.15)$$

$$K_V = \frac{F_V}{S_2} = \frac{F_V}{S_1 \tan \theta} = \frac{F_V}{S_1 \alpha} \times \frac{\alpha}{\tan \theta} = K_2 \times \frac{\alpha}{\tan \theta} \quad (1.16)$$

The parameters for each component are set as follows.

The vertical compression displacement $S_2$ of the buffer body 3 is tangent to the horizontal sliding displacement $S_1$ of the first component 61. When the horizontal sliding displacement $S_1$ of the first component 61 remains unchanged, the larger the inclination angle $\theta$ of the inclined surface 41 of the force transmission member 4, the larger the vertical compression displacement $S_2$ of the buffer body 3.

The vertical reaction force $F_V$ of the buffer body 3 is a product of a difference between the static friction forces $f_1$ generated by the external horizontal force $F_{H1}$ and the external vertical force P, respectively, and the force transmission coefficient $\alpha$. When both the external horizontal force $F_{H1}$ and the static friction forces $f_1$ remain unchanged, the larger the inclination angle $\theta$ of the inclined surface 41 of the force transmission member 4 and the smaller the force transmission coefficient $\alpha$, the smaller the vertical reaction force $F_V$ of the buffer body 3.

The horizontal reaction force $F_{H2}$ of the screw 11 of the bolt 1 is a product of the difference between the static friction forces $f_1$ generated by the external horizontal force $F_{H1}$ and the external vertical force P, respectively, and the force transmission coefficient $\beta$. When both the external horizontal force $F_{H1}$ and the static friction forces $f_1$ remain unchanged, the larger the inclination angle $\theta$ of the inclined surface 41 of the force transmission member 4 and the larger the force transmission coefficient $\beta$, the larger the horizontal reaction force $F_{H2}$ of the screw 11 of the bolt 1.

When the horizontal sliding displacement $S_1$ of the first component 61, the external horizontal force $F_{H1}$, and the static friction forces $f_1$ all remain unchanged, the larger the inclination angle $\theta$ of the inclined surface 41 of the force transmission member 4, the smaller the vertical reaction force $F_V$ of the buffer body 3, the larger the vertical compression displacement $S_2$, and the smaller the ratio between the two, i.e. the smaller the vertical stiffness $K_V$ of the buffer body 3. The larger the vertical compression displacement $S_2$ of the buffer body 3, the larger a free height of the buffer body 3 before compression, and the larger an overall height H thereof, as shown in Fig. 4.

When both the external horizontal force $F_{H1}$ and the static friction forces $f_1$ remain unchanged, the horizontal reaction force $F_{H2}$ of the screw 11 of the bolt 1 and the vertical reaction force $F_V$ of the buffer body 3 are negatively correlated with the inclination angle $\theta$ of the inclined surface 41 of the force transmission member 4. As the horizontal reaction force $F_{H2}$ of the screw 11 of the bolt 1 decreases, the vertical reaction force $F_V$ of the buffer body 3 increases. For a force transmission member 4 of the inclined surface 41 with a smaller inclination angle $\theta$, the vertical compression displacement $S_2$ of the buffer body 3 is smaller, and the vertical stiffness $K_V$ is larger.

When the buffer body 3 includes a disc spring element 30, the disc spring body 32 can be designed as follows. The first component 61 undergoes the horizontal sliding displacement $S_1$ under the external horizontal force $F_{H1}$. According to the equation (1.9), the buffer body 3 undergoes the vertical compression displacement $S_2$ due to the force transmission member 4. A deformation amount $f_c$ of the buffer body 3 should be larger than or equal to $S_2$. If n combined disc spring elements 30 withstand a vertical bearing capacity $F_V$ (i.e. the vertical reaction force of the buffer body 3), a vertical bearing capacity of a single disc spring element 30 is $F_V / n$. Therefore, the buffer body 3 can be designed such that each disc spring element 30 withstands $F_V / n$, and the deformation amount of the buffer body 3 is $S_2$.

The diameter of the screw 11 is the nominal diameter of the bolt. Based on the dimension of the screw 11, the disc spring element 30 with a suitable inner diameter is selected. According to the national disc spring design standard of China *"Disc Springs"* (GB/T 1972), the stiffness $K_V$ of the buffer body 3 is determined.

It should be understood that in the present invention, the terms "first" and "second" are used for illustrative purposes only, and are not intended to indicate or imply relative importance or implicitly specify the number of technical features indicated. Thus, the technical features defined with the terms "first" or "second" may explicitly or implicitly include one or more such technical features. In the description of the present invention, "a plurality of" means two or more, unless otherwise specified.

In the present invention, unless otherwise specified or defined, the phrases "mount", "connect", "attach", "fix" and the like, should be understood in a broad sense, and may be understood as, for example, fixed connections, detachable connections, or integral connections; mechanical or electrical connections; direct connections or indirect connections via intermediate structure; or interior communication between two elements. The specific meanings of the above phrases in the present invention can be understood by one skilled in the art in accordance with specific conditions.

The phrases "an embodiment", "some embodiments", "example", "specific example" or "some examples" as mentioned in the description mean that the particular features, structures, materials or characteristics described in conjunction with the embodiment or example are included in at least one embodiment or example of the present invention. Thus, the above illustrative phrases described throughout the description do not necessarily refer to the same embodiment or example. Moreover, the particular features, structures, materials, or characteristics described herein may be combined in any one or more of the embodiments or examples in a suitable manner.

Finally, it should be noted that the foregoing description is merely illustrative of preferred embodiments of the present invention, and is not intended to restrict the present invention. Although the present invention is described in detail with reference to the above embodiments, it is still possible for one skilled in the art to modify the technical solutions defined in the above embodiments or to replace some of the technical features with equivalent ones. Any modifications, equivalent substitutions, improvements, and the like falling within the spirit and principles of the present invention are intended to be included within the scope of protection of the present invention.

**Claims**

1. A buffer connection device (100) for connecting at least a first component (61) and a second component (62), the device comprising:

   a bolt (1) including a screw (11) and a head (12), the screw (11) passing through a first through hole (611) of the first component (61) and extending to at least the second component (62), in order to connect the first component (61) and the second component (62) together; and
   a force transmission member (4) arranged between the head (12) and the first component (61), and configured such that a central axis of the first through hole (611) of the first component (61) remains to substantially coincide with a central axis of the head (12).

2. The buffer connection device according to claim 1, **characterized in that** the force transmission member (4) fits the first component (61) through an inclined surface (41), and is configured to receive a preload force directed towards said first component (61), so that the central axis of the first through hole (611) of the first component (61) remains to substantially coincide with that of the head (12) through the inclined surface (41) and the preload force.

3. The buffer connection device according to claim 2, **characterized in that** a buffer body (3) configured to generate said preload force is arranged between the force transmission member (4) and the head (12).

4. The buffer connection device according to claim 3, **characterized in that** said buffer body (3) is at least one of a helical spring, a disc spring, or an elastic element.

5. The buffer connection device according to claim 4, **characterized in that** the buffer body (3) comprises at least one disc spring element (30) arranged coaxially, which comprises a disc spring body (32) for receiving a vertical force, and a guide ring (31) arranged coaxially within the disc spring body (32) for engaging with the screw (11).

6. The buffer connection device according to claim 5, **characterized in that** a thickness of said guide ring (31) is less than that of said disc spring body (32).

7. The buffer connection device according to any one of claims 3 to 6, **characterized in that** a guide cylinder (33) is arranged around said buffer body (3) for preventing eccentric loading of said buffer body (3).

8. The buffer connection device according to claim 7, **characterized in that** a washer (2) is arranged between the buffer body (3) and the head (12), wherein a first end of said guide cylinder (33) is connected to said washer (2), and a second end thereof is in contact with said first component (61).

9. The buffer connection device according to any one of claims 1 to 8, **characterized in that** said force transmission member (4) is configured as any one of a truncated cone, a prismatic frustum, and a spherical segment, thereby forming said inclined surface (41).

10. The buffer connection device according to any one of claims 2 to 9, **characterized in that** an inclination angle of said inclined surface (41) is 10° to 60°.

11. The buffer connection device according to any one of claims 3 to 10, **characterized in that** said buffer body has a vertical stiffness $K_V$, which is obtained by an equation:

$$K_V = F_V / S_2$$

wherein $F_V$ denotes a vertical reaction force of said buffer body, and $S_2$ denotes a vertical compression displacement of said buffer body under $F_V$;
the vertical reaction force $F_V$ is obtained by an equation:

$$F_V = \alpha \left( F_{H1} - \mu_1 P \right)$$

wherein $\alpha$ denotes a force transmission coefficient of the buffer body, $F_{H1}$ denotes an external stress on the first component, $\mu_1$ denotes a sliding friction coefficient between the first component and the second component, and $P$ denotes an external vertical force between the first component and the second component;
the vertical compression displacement $S_2$ is obtained by an equation:

$$S_2 = S_1 \tan \theta$$

wherein $S_1$ denotes a horizontal sliding displacement of said first component under said external stress, and $\theta$ denotes the inclination angle of said inclined surface; and
the external stress $F_{H1}$ is obtained by an equation:

$$F_{H1} = \frac{F_V}{\alpha} + \mu_1 P .$$

12. The buffer connection device according to any one of claims 1 to 11, **characterized in that** said buffer connection device has an initial stiffness $K_1$, which is obtained by an equation:

$$K_1 = \mu_1 \frac{P}{S_0}$$

wherein:

$\mu_1$ denotes the sliding friction coefficient between the first component and the second component;
$P$ denotes the external vertical force between the first component and the second component; and
$S_0$ denotes a horizontal sliding displacement when said first component overcomes static friction and begins to slide.

13. The buffer connection device according to claim 12, **characterized in that** said buffer connection device has a post-yield stiffness $K_2$, which is obtained by equations:

$$K_2 = \frac{F_V}{\alpha S_1} \text{ or } K_2 = \frac{F_{H1} - \mu_1 P}{S_1 - S_0}$$

wherein $\alpha$ denotes the force transmission coefficient of the buffer body, $S_1$ denotes the horizontal sliding displacement of said first component under said external stress $F_{H1}$, where $S_1$ is larger than $S_0$, $F_{H1}$ denotes said external stress, $\mu_1$ denotes the sliding friction coefficient between the first component and the second component, and $P$ denotes the external vertical force between the first component and the second component.

14. The buffer connection device according to any one of claims 11 to 13, **characterized in that** the force transmission coefficient $\alpha$ of the buffer body is obtained by an equation:

$$\alpha = \frac{(1 - \mu_2\mu_3)\cos\theta - (\mu_2 + \mu_3)\sin\theta}{(\mu_1 + \mu_2)\cos\theta + (1 - \mu_1\mu_2)\sin\theta}$$

wherein $\mu_2$ denotes a sliding friction coefficient between the inclined surface of the force transmission member and the first component, $\mu_3$ denotes a sliding friction coefficient between the bolt and the force transmission member, and $\theta$ denotes the inclination angle of said inclined surface.

15. The buffer connection device according to any one of claims 1 to 14, **characterized in that** the bolt has a horizontal reaction force $F_{H2}$, which is obtained by an equation:

$$F_{H2} = \beta(F_{H1} - \mu_1 P)$$

wherein $F_{H2}$ denotes the horizontal reaction force of the bolt, $\beta$ denotes a force transmission coefficient of the bolt, $F_{H1}$ denotes the external stress, $\mu_1$ denotes the sliding friction coefficient between the first component and the second component, and $P$ denotes the external vertical force between the first component and the second component.

16. The buffer connection device according to claim 15, **characterized in that** the force transmission coefficient $\beta$ of the bolt is obtained by an equation:

$$\beta = \frac{\mu_2\cos\theta + \sin\theta}{(\mu_1 + \mu_2)\cos\theta + (1 - \mu_1\mu_2)\sin\theta}$$

wherein $\mu_2$ denotes the sliding friction coefficient between the inclined surface of the force transmission member and the first component, and $\theta$ denotes the inclination angle of said inclined surface.

17. A parameter calculation method of the buffer connection device according to any one of claims 3 to 10, **characterized in that** a vertical stiffness $K_V$ of the buffer body is obtained by an equation:

$$K_V = F_V / S_2$$

wherein $F_V$ denotes a vertical reaction force of the buffer body, and $S_2$ denotes a vertical compression displacement of said buffer body under $F_V$;
the vertical reaction force $F_V$ is obtained by an equation:

$$F_V = \alpha \left( F_{H1} - \mu_1 P \right)$$

wherein $\alpha$ denotes a force transmission coefficient of the buffer body, $F_{H1}$ denotes an external stress on the first component, $\mu_1$ denotes a sliding friction coefficient between the first component and the second component, and $P$ denotes an external vertical force between the first component and the second component;
the vertical compression displacement $S_2$ is obtained by an equation:

$$S_2 = S_1 \tan \theta$$

wherein $S_1$ denotes a horizontal sliding displacement of said first component under said external stress, and $\theta$ denotes the inclination angle of said inclined surface; and
the external stress $F_{H1}$ is obtained by an equation:

$$F_{H1} = \frac{F_V}{\alpha} + \mu_1 P \,.$$

18. The parameter calculation method according to claim 17, **characterized in that** an initial stiffness $K_1$ of said buffer connection device is obtained by an equation:

$$K_1 = \mu_1 \frac{P}{S_0}$$

wherein:

$\mu_1$ denotes a sliding friction coefficient between the first component and the second component;
$P$ denotes an external vertical force between the first component and the second component; and
$S_0$ denotes a horizontal sliding displacement when said first component overcomes static friction and begins to slide; and
a post-yield stiffness $K_2$ of said buffer connection device is obtained by equations:

$$K_2 = \frac{F_V}{\alpha S_1} \quad \text{or} \quad K_2 = \frac{F_{H1} - \mu_1 P}{S_1 - S_0}$$

wherein $\alpha$ denotes the force transmission coefficient of the buffer body, $S_1$ denotes the horizontal sliding displacement of said first component under said external stress $F_{H1}$, where $S_1$ is larger than $S_0$, $F_{H1}$ denotes said external stress, $\mu_1$ denotes the sliding friction coefficient between the first component and the second component, and $P$ denotes the external vertical force between the first component and the second component.

19. The parameter calculation method according to claim 17 or 18, **characterized in that** the force transmission coefficient $\alpha$ of the buffer body is obtained by an equation:

$$\alpha = \frac{\left(1 - \mu_2 \mu_3\right) \cos\theta - \left(\mu_2 + \mu_3\right) \sin\theta}{\left(\mu_1 + \mu_2\right) \cos\theta + \left(1 - \mu_1 \mu_2\right) \sin\theta}$$

wherein $\mu_2$ denotes a sliding friction coefficient between the inclined surface of the force transmission member and the first component, $\mu_3$ denotes a sliding friction coefficient between the bolt and the force transmission member, and $\theta$ denotes the inclination angle of said inclined surface.

20. The parameter calculation method according to any one of claims 17 to 19, **characterized in that** a horizontal reaction force $F_{H2}$ of the bolt is obtained by an equation:

$$F_{H2} = \beta\left(F_{H1} - \mu_1 P\right)$$

wherein $F_{H2}$ denotes the horizontal reaction force of the bolt, $\beta$ denotes a force transmission coefficient of the bolt, $F_{H1}$ denotes the external stress, $\mu_1$ denotes the sliding friction coefficient between the first component and the second component, and $P$ denotes the external vertical force between the first component and the second component; and
the force transmission coefficient $\beta$ of the bolt is obtained by an equation:

$$\beta = \frac{\mu_2 \cos\theta + \sin\theta}{\left(\mu_1 + \mu_2\right)\cos\theta + \left(1 - \mu_1\mu_2\right)\sin\theta}$$

wherein $\mu_2$ denotes a sliding friction coefficient between the inclined surface of the force transmission member and the first component, and $\theta$ denotes the inclination angle of said inclined surface.

**Fig. 1**

**Fig. 2**

100

Fig. 3

Fig. 4

30    31    32

t    t₁

**Fig. 5**

32    31    30

**Fig. 6**

**Fig. 7**

**Fig. 8**

**Fig. 9**

**Fig. 10**

**Fig. 11**

Inclination angle of inclined surface of force transmission member  θ/°

**Fig. 12**

**Fig. 13**

**Fig. 14**

## INTERNATIONAL SEARCH REPORT

| International application No. |
| --- |
| **PCT/CN2025/126427** |

| A. | CLASSIFICATION OF SUBJECT MATTER |
| --- | --- |

F16F3/02(2006.01)i; F16F15/02(2006.01)i; G06F30/17(2020.01)i

According to International Patent Classification (IPC) or to both national classification and IPC

| B. | FIELDS SEARCHED |
| --- | --- |

Minimum documentation searched (classification system followed by classification symbols)

IPC: F16F G06F

Documentation searched other than minimum documentation to the extent that such documents are included in the fields searched

Electronic data base consulted during the international search (name of data base and, where practicable, search terms used)

CNKI, IEEE, CNABS, VEN, CNTXT, USTXT, EPTXT, WOTXT: 螺栓, 螺钉, 螺母, 螺杆, 缓冲, 弹簧, 碟簧, 垫片, 刚度, 位移, 摩擦系数, bolt, screw, rod, nut, buffer, spring, gasket, stiffness, displacement, coefficient, friction

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 119475611 A (ZHUZHOU TIMES NEW MATERIAL TECHNOLOGY CO., LTD.) 18 February 2025 (2025-02-18) <br> description, paragraphs 107-155, and claims 1-11 | 1-20 |
| PX | CN 119103284 A (ZHUZHOU TIMES NEW MATERIAL TECHNOLOGY CO., LTD.) 10 December 2024 (2024-12-10) <br> description, paragraphs 39-57, and claims 1-10 | 1-10 |
| X | CN 110847939 A (CHINA RAILWAY FOURTH SURVEY AND DESIGN INSTITUTE GROUP CO., LTD.) 28 February 2020 (2020-02-28) <br> description, paragraphs 23-29, and figures 1-4 | 1, 9-10 |
| Y | CN 110847939 A (CHINA RAILWAY FOURTH SURVEY AND DESIGN INSTITUTE GROUP CO., LTD.) 28 February 2020 (2020-02-28) <br> description, paragraphs 23-29, and figures 1-4 | 2-8 |
| Y | CN 213899564 U (SICHUAN PROVINCE BOJUN MACHINERY MANUFACTURING CO., LTD.) 06 August 2021 (2021-08-06) <br> description, paragraphs 22-26, and figures 1-2 | 2-8 |

☑ Further documents are listed in the continuation of Box C. ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **15 December 2025** | **25 December 2025** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2025/126427** |

**C.    DOCUMENTS CONSIDERED TO BE RELEVANT**

| Category* | Citation of document, with indication, where appropriate, of the relevant passages | Relevant to claim No. |
|---|---|---|
| A | CN 110287593 A (NORTHEASTERN UNIVERSITY) 27 September 2019 (2019-09-27) entire document | 1-20 |
| A | WO 2022255733 A1 (CHUNGAMENC CO., LTD.) 08 December 2022 (2022-12-08) entire document | 1-20 |

Form PCT/ISA/210 (second sheet) (July 2022)

**INTERNATIONAL SEARCH REPORT**
**Information on patent family members**

International application No.

**PCT/CN2025/126427**

| Patent document cited in search report | | | Publication date (day/month/year) | Patent family member(s) | | | Publication date (day/month/year) |
|---|---|---|---|---|---|---|---|
| CN | 119475611 | A | 18 February 2025 | None | | | |
| CN | 119103284 | A | 10 December 2024 | None | | | |
| CN | 110847939 | A | 28 February 2020 | CN | 211448712 | U | 08 September 2020 |
| CN | 213899564 | U | 06 August 2021 | None | | | |
| CN | 110287593 | A | 27 September 2019 | None | | | |
| WO | 2022255733 | A1 | 08 December 2022 | EP | 4350120 | A1 | 10 April 2024 |
| | | | | EP | 4350120 | A1 | 10 April 2024 |
| | | | | KR | 102339930 | B1 | 15 December 2021 |
| | | | | CN | 115434996 | A | 06 December 2022 |
| | | | | CN | 217898426 | U | 25 November 2022 |

Form PCT/ISA/210 (patent family annex) (July 2022)

**EP 4 752 395 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202411393912X

- CN 202411393911